# EUROPEAN PATENT APPLICATION

(11) **EP 4 766 081 A1**
(43) Date of publication of application: **24.06.2026**
(21) Application number: 24221652.1
(22) Date of filing: 19.12.2024
(51) Int. Cl.: H10D 30/69, H10D 84/01, H10D 84/03, H10D 84/83, H10D 84/85, H10D 88/00

(54) **A COMPLEMENTARY METAL-OXIDE-SEMICONDUCTOR (CMOS) FIELD EFFECT DEVICE**

(71) Applicant: Imec VZW, 3001 Leuven (BE)
(72) Inventor: HELLINGS, Geert, 1500 Halle (BE); ENEMAN, Geert, 3001 Heverlee (BE)
(74) Representative: AWA Sweden AB

(57) **Abstract**

The present invention provides a complementary metal-oxide-semiconductor (CMOS) field effect device comprising a substrate; a first n-doped S/D region and a second n-doped S/D region; a first p-doped S/D region and a second p-doped S/D region; a first channel layer arranged above the substrate, the first channel layer comprising: a first sub-layer and a second sub-layer; wherein the first and second n-doped S/D regions are arranged at a first lateral side of the first channel layer, and the first and second p-doped S/D regions are arranged at a second lateral side of the first channel layer, the second lateral side being opposite to the first lateral side; wherein a conduction band edge of the first sub-layer has an energy below a conduction band edge of the second sub-layer; and wherein a valence band edge of the first sub-layer has an energy below a valence band edge of the second sub-layer; and a gate structure abutting the first and second sublayers of the first channel layer.

## Description

### TECHNICAL FIELD

The present disclosure relates to a complementary metal-oxide-semiconductor (CMOS) field effect device.

### BACKGROUND

A complementary metal-oxide-semiconductor (CMOS) field effect device utilizes both p-type and n-type MOSFETs (Metal-Oxide-Semiconductor Field-Effect Transistors) to create logic functions. A C2MOS device, alternatively denoted as a shared-channel CMOS device, is a type of a CMOS device wherein a p-type MOSFET and a n-type MOSFET share a same channel and a same gate. In such a CMOS device, the same channel will conduct electrons when the n-type MOSFET is activated, and holes when the p-type MOSFET is activated.

### SUMMARY

It is an objective of the present inventive concept to provide a CMOS device having improved electrical performance. A further objective is to provide a CMOS device having a small footprint. Further and alternative objectives may be understood from the following.

According to a first aspect of the invention, there is provided a CMOS device, the CMOS device comprising:
a substrate;
a first n-doped source/drain region, S/D region, and a second n-doped S/D region, arranged above the substrate;
a first p-doped S/D region and a second p-doped S/D region, arranged above the substrate;
a first channel layer arranged above the substrate, the first channel layer comprising:
   a first sub-layer and a second sub-layer;
wherein the first and second n-doped S/D regions are arranged at a first lateral side of the first channel layer, and the first and second p-doped S/D regions are arranged at a second lateral side of the first channel layer, the second lateral side being opposite to the first lateral side;
wherein the first and second n-doped S/D regions abut the first sub-layer but not the second sub-layer;
wherein the first and second p-doped S/D regions abut the second sub-layer but not the first sub-layer;
wherein a conduction band edge of the first sub-layer has an energy below a conduction band edge of the second sub-layer; and
wherein a valence band edge of the first sub-layer has an energy below a valence band edge of the second sub-layer; and
a gate structure abutting the first and second sub-layers of the first channel layer.

The substrate may be a silicon substrate. It should be noted that any references to an element, e.g. the first channel, being arranged above the substrate implies that there may be arranged e.g. an intermediate layer, or structure, between the substrate and the first channel. Hence, it is implied that the first channel layer may be arranged on, and in physical contact with, that intermediate layer. That intermediate layer may be a functional gate structure, or a portion thereof, or an intermediate dielectric layer.

As mentioned, the CMOS device comprises a first channel layer. As will be discussed below, the CMOS device may comprise further channel layers. However, for now only the first channel layer and the associated S/D regions and gate structure will be discussed. The first channel layer comprises a first and a second sub-layer. The first and a second sub-layers may be arranged very close to each other, e.g. abutting each other. By way of example, a major surface of the first sub-layer may be in abutment with a major surface of the second sub-layer. Alternatively, it is contemplated that a lateral side of the first sub-layer may be arranged in abutment with a lateral side of the second sub-layer. Thus, the CMOS device may be compact, just like a conventional C2MOS device is compact. The first channel layer may be patterned to form a nanosheet, or fins. Likewise, the sub-layers of the first channel layer may be patterned to form nanosheets, or fins. As mentioned, the gate structure abuts the first and second sub-layers of the first channel layer. For example, the gate structure may wrap around the first channel layer. Accordingly, the gate structure may be a wrap-around-gate (also called gate-all-around i.e. GAA) around the first channel layer. For example, the gate structure may abut the first and second lateral side surface of the first channel layer as well as a top and bottom surface of the first channel layer. The gate structure may be arranged between the first and second n-doped S/D regions and between the first and second p-doped S/D regions. A gate structure as discussed herein may include gate spacers, a gate dielectric, and a gate metal.

Since the first and second n-doped S/D regions abut the first sub-layer, the first sub-layer may conduct electrons between the first and second n-doped S/D regions. Similarly, since the first and second p-doped S/D regions abut the second sub-layer, the second sub-layer may conduct holes between the first and second p-doped S/D regions.

In accordance with the above, the first and second n-doped S/D regions and the first sub-layer of the first channel layer may form part of a n-type MOSFET while the first and second p-doped S/D regions and the second sub-layer of the first channel layer may form part of a p-type MOSFET, wherein the n-type MOSFET and the p-type MOSFET have a common gate structure.

In a conventional shared channel CMOS device, both the n-type MOSFET and the p-type MOSFET will be associated with one single homogeneous channel, and thereby that single homogeneous channel will be used to conduct both electrons and holes. It is a realization that such a conventional shared channel CMOS device may suffer from a limited on-current and/or excessively high leakage currents. For example, when the n-type MOSFET is gated on and the p-type MOSFET is gated off, there may be a leakage current from one of the n-doped S/D regions to one of the p-doped S/D regions.

In contrast, in the present invention the first channel layer comprises a first and second sub-layer, wherein the band-alignment is such that the conduction band edge of the first sub-layer has an energy below a conduction band edge of the second sub-layer; and the valence band edge of the first sub-layer has an energy below a valence band edge of the second sub-layer. For example, the band-alignment of the first and second sub-layers may be staggered. Thus, the band-alignment of the first and second sub-layers may confine electrons to the first sub-layer and holes to the second sub-layer. This results in a higher on-current and/or reduced leakage currents, while the CMOS device still is compact. Further, the present invention enables the first sub-layer to be optimized (or tailored) to electron conduction and/or the second sub-layer to be optimized (or tailored) to hole conduction. This may further improve the on-current.

The first sub-layer may form part of a n-type MOSFET. The first sub-layer may thus be optimized for electron conduction. To this end, the first sub-layer may be formed such that the material thereof has a high electron mobility, e.g. a higher electron mobility than the second sub-layer. The material of the first sub-layer may further be configured such that the conduction band edge energy is comparably low relative to the conduction band edge energy of the material of the second sub-layer. Such a configuration facilitates to confine the electrons within the first sub-layer.

The second sub-layer may form part of a p-type MOSFET. The second sub-layer may thus be optimized for hole conduction. Hence, it is implied that the second sub-layer may be formed such that the material thereof has a high hole mobility, e.g. a higher hole mobility than the first sub-layer. The material of the second sub-layer may further be configured such that the valence band edge energy is comparably high relative to the valence band edge energy of the material of the first sub-layer. Such a configuration facilitates to confine the holes within the second sub-layer.

The first aspect of the invention is based on the insight that prior art C2MOS devices, while having a reduced cell area and a reduced gate capacitance compared to conventional CMOS devices, still suffer from issues related to leakage current. In this context, leakage current may refer to primary charge carriers of a MOSFET having a certain conductivity undesirably traversing to the other MOSFET having an opposite conductivity during forward biasing.

The present CMOS device employs a channel comprising a stack of a first sub-layer and a second sub-layer. By a conduction band edge of the first sub-layer having an energy below a conduction band edge of the second sub-layer, the first sub-layer may be optimized for electron conduction. Such a configuration facilitates to confine the electrons within the first sub-layer. By a valence band edge of the first sub-layer having an energy below a valence band edge of the second sub-layer, the second sub-layer may be optimized for hole conduction. Such a configuration facilitates to confine the holes within the second sub-layer. Further, the first and second sub-layers may form an interface therebetween. It is implied that the first sub-layer may be in abutment with the second sub-layer. The merit of the above configurations of the conduction and valence band edges implies that a band-alignment at said interface is formed such that the leakage current is reduced during forward biasing of the CMOS device. As discussed above, this is achieved by confining, or alternatively expressed "trapping" the respective primary charge carrier in its respective sub-layer.

It is further implied that the configurations of the conduction and valence band edges imply that the first and second sub-layers may form a heterostructure, i.e. the first and second sub-layers may be formed of different materials. Hence, there is provided a greater degree of freedom concerning the choice of material of the first and second sub-layers. As such, the materials of the first and second sub-layers may be chosen to have a small lattice mismatch. Thus, there may be enabled a channel layer with reduced epitaxial growth induced defects, such as e.g. dislocations. Consequently, there is provided improved electrical performance and thus a high-quality CMOS device. It is also implied that the materials of the first and second sub-layers may be chosen such that the electron mobility is high in the first sub-layer and such that the hole mobility is high in the second sub-layer, thereby improving the drive current of the n-type MOSFET and the p-type MOSFET.

Further, in prior art C2MOS devices having a shared channel, the shared channel is typically formed of a single material. Thereby, the conduction will typically be skewed towards one type of conductivity in the sense that the material will be optimized for either electron conduction or hole conduction. For instance, the shared channel may be formed of Si. However, Si has a significantly higher electron mobility than hole mobility, hence optimizing the electron conduction which is more beneficial for the n-type MOSFET than the p-type MOSFET. This results in a high drive current for the n-type MOSFET and a low drive current for the p-type MOSFET. The present CMOS device obviates this issue by the channel comprising a first sub-layer formed of a material that provides optimal electron conduction and thereby an improved drive current for the n-type MOSFET, and a second sub-layer formed of a material that provides optimal hole conduction and thereby an improved drive current for the p-type MOSFET.

The first aspect of the invention is also based on the insight that a small footprint may be achieved by arranging the n-doped and p-doped S/D regions at a respective lateral side of the first channel layer. By having a small footprint, it is herein generally meant that a thin device may be provided. Further, by arranging the n-doped and p-doped S/D regions at a respective lateral side, e.g. opposite lateral side, of the first channel layer they are well separated such that the first and second sub-layers may be arranged close to each other, e.g. abutting each other, without the n-doped and p-doped S/D regions coming into contact with each other.

Relative spatial terms such as "topmost", "bottom", "lower", "vertical", "stacked on top of', are herein to be understood as denoting locations or directions within a frame of reference of the semiconductor substrate. In particular, the terms may be understood in relation to a normal direction to the substrate on/above which the stack of channel layers is formed, or equivalently in relation to a bottom-up/stacking direction of the channel layers. The term "lateral surface" or equivalent is herein meant surfaces of the channel layers/sub-layers of the channel layers which are perpendicular to the substrate.

The term "CMOS device" need not imply that the CMOS device comprises a single pair of a n-type MOSFET and a p-type MOSFET. On the contrary, the CMOS device may comprise a plurality of pairs of n-type and p-type MOSFETs, e.g. two, three, four, five, or more pairs.

The use of first, second, etc., are mainly to be seen as labels facilitating reading and that it does not necessarily mean that there needs to be further/all the intervening numbers of portions present. To this end, the CMOS device is not limited to comprising one or two channel layers. In fact, the CMOS device may comprise more than two channel layers, wherein each channel layer comprises a sub-layer optimized for electron conduction and a sub-layer optimized for hole conduction. For instance, the CMOS device may comprise three, four, five, or more channel layers. The channel layers may be separated from each other by means of a dielectric layer.

The second sub-layer may comprise Si₁₋ₓGeₓ, wherein x is equal to or less than 1.

Thereby, the second sub-layer may be formed of a material having a comparably high hole mobility. An improved drive current with regard to the p-type MOSFET may thus be provided.

The first sub-layer may comprise Si.

Thereby, the second sub-layer may be formed of a material having a comparably high electron mobility. An improved drive current with regard to the n-type MOSFET may thus be provided.

The first sub-layer may be tensile strained. The second sub-layer may be compressively strained.

An energy difference between the conduction band edge of the first sub-layer and the valence band edge of the second sub-layer may be equal to or greater than 400 meV.

Such an energy difference may provide a sufficient energy barrier to prevent band-to-band tunneling . In other words, such an energy difference may prevent an electron in the conduction band of the first sub-layer from tunneling into the valence band of the second sub-layer. Similarly, such an energy difference may prevent a hole in the valence band of the second sub-layer from tunneling into the conduction band of the first sub-layer layer. Thereby, leakage current may be reduced.

An energy difference between the conduction band edge of the second sub-layer and the conduction band edge of the first sub-layer may be greater than 100 meV. An energy difference between the valence band edge of the second sub-layer and the valence band edge of the first sub-layer may be greater than 100 meV.

Such energy differences may be seen as band offsets in the conduction bands and in the valence bands, respectively. Such energy differences may provide sufficient energy barriers for the electrons and holes. Thereby, leakage current may be reduced.

A plane of the first channel layer may be arranged parallel to the substrate;
wherein the first and second n-doped S/D regions may abut at least one of: a top surface of the first sub-layer; a bottom surface of the first sub-layer; a lateral side surface of the first sub-layer, and
wherein the first and second p-doped S/D regions may abut at least one of: a top surface of the second sub-layer; a bottom surface of the second sub-layer; a lateral side surface of the second sub-layer.

It may alternatively be expressed that a main plane of the first channel layer may be arranged parallel to a main plane of the substrate.

The CMOS device may further comprise:
a second channel layer arranged above the first channel layer comprising:
   a first sub-layer and a second sub-layer;
wherein the second sub-layer of the first channel layer is arranged above the first sub-layer of the first channel layer, and the second sub-layer of the second channel is arranged below the first sub-layer of the second channel layer, and wherein the first and second p-doped S/D regions abut the second sub-layers of the first and second channel layers, or
wherein the first sub-layer of the first channel layer is arranged above the second sub-layer of the first channel layer, and the first sub-layer of the second channel is arranged below the second sub-layer of the second channel layer, and wherein the first and second n-doped S/D regions abut the first sub-layers of the first and second channel layers.

Whenever there is a reference to the second channel layer, the above discussions about the first channel layer and its sub-layers concerning band-alignment, geometry, dimensions, material, arrangement etc, are equally applicable to the second channel layer and its sub-layers, unless otherwise stated.

The gate structure may further abut the first and second sub-layers of the second channel layer.

The gate structure may form a common gate structure for the first and second channel layers. For instance, both the first and second channel layers may be provided with a wrap-around-gate (i.e. GAA). The gate structure may surround the first and second channel layers. The gate structure may thus control both the first and second channel layers.

The CMOS device may further comprise first and second n-doped S/D regions associated with the second channel, and first and second p-doped S/D regions associated with the second channel.

A plane of the first channel layer may be arranged perpendicular to the substrate.

It may alternatively be expressed that a main plane of the first channel layer may be arranged perpendicular to a main plane of the substrate.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

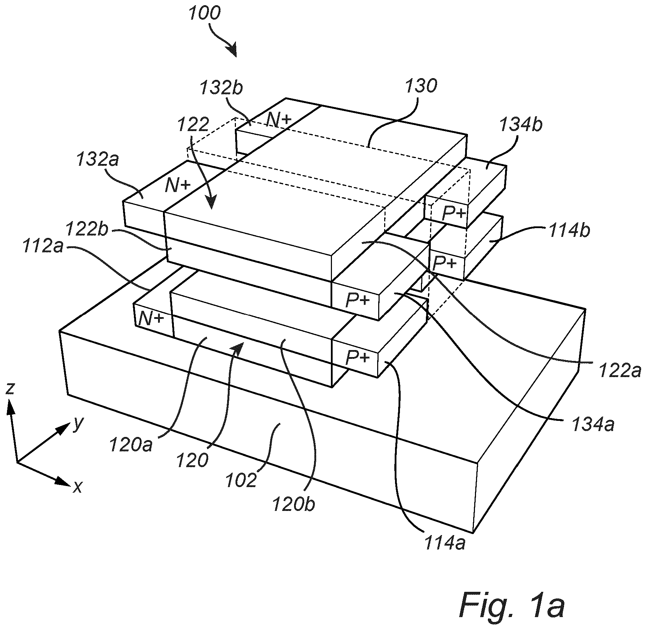

Figs. 1a-c illustrate three CMOS devices in schematically depicted perspective views.

### DETAILED DESCRIPTION

In the following, three different CMOS devices will be exemplified. In the figures discussed below, axes X, Y, and Z indicate a first direction, a second direction transverse to the first direction, and a vertical or bottom-up direction, respectively. The X- and Y-direction may in particular be referred to as lateral or horizontal directions in that they are parallel to a main plane of the substrate. The Z-direction is parallel to a normal direction of the frontside of the substrate. In the finished CMOS devices, the current flows primarily in the X-direction. Whenever there is a reference to a layer being formed, this is preferably performed using conventional semiconductor fabrication technology, such as metalorganic chemical vapour deposition (MOCVD), physical vapor deposition (PVD), atomic layer deposition (ALD), thin-film deposition, or the like.

Referring now to Fig. 1a, a first CMOS device 100 is illustrated. The CMOS device 100 comprises a substrate 102. The substrate 102 may be a conventional semiconductor substrate suitable for e.g. complementary metal-oxide semiconductor (CMOS). The substrate 102 may for instance be a semiconductor bulk substrate such as a Si substrate, a germanium (Ge) substrate or a silicon-germanium (SiGe) substrate. Other examples include a semiconductor-on-insulator (SOI) type of substrate such as a Si-on-insulator substrate, a Ge-on-insulator substrate, or a SiGe-on-insulator substrate.

The CMOS device 100 further comprises a first channel layer 120. The first channel layer 120 may be in abutment with the substrate 102. However, as depicted in Fig. 1a, the first channel layer 120 is generally arranged above the substrate 102 such that there is a gap therebetween. In that gap there may be arranged an intermediate layer. Such an intermediate layer may be e.g. part of a wrap-around-gate structure, or a dielectric layer.

The first channel layer 120 comprises a first sub-layer 120a and a second sub-layer 120b. The first sub-layer 120a forms part of a n-type MOSFET. The second sub-layer 120b forms part of a p-type MOSFET.

The first channel layer 120 is patterned such that it forms a nanosheet. Likewise, the sub-layers of the first channel layer 120 are patterned to form nanosheets.

The CMOS device 100 comprises a first n-doped S/D region 112a and a second (non-illustrated) n-doped S/D region 112b. The first n-doped S/D region 112a and the second n-doped S/D region 112b are arranged above the substrate 102. The first and second n-doped regions 112a, 112b are arranged at a first lateral side of the first channel layer 120. More specifically, the first and second n-doped regions 112a, 112b are arranged at a lateral side of the first sub-layer 120a. Thereby, the first and second n-doped regions 112a, 112b are associated with the first sub-layer 120a. The first and second n-doped S/D regions 112a, 112b abut the first sub-layer 120a but not the second sub-layer 120b. The first and second n-doped S/D regions 112a, 112b may abut a lateral side of the first sub-layer 120a. Together, the first and second n-doped regions 112a, 112b and the first sub-layer 120a form part of the n-type MOSFET.

Similarly, the CMOS device 100 comprises a first p-doped S/D region 114a and a second p-doped S/D region 114b. The first p-doped S/D region 114a and the second p-doped S/D region 114b are arranged above the substrate 102. The first and second p-doped regions 114a, 114b are arranged at a second lateral side of the first channel layer 120. More specifically, the first and second p-doped regions 114a, 114b are arranged at a lateral side of the second sub-layer 120b. Thereby, the first and second p-doped regions 114a, 114b are associated with the second sub-layer 120b. The first and second p-doped S/D regions 114a, 114b abut the second sub-layer 120b but not the first sub-layer 120a. The first and second p-doped S/D regions 114a, 114b may abut a lateral side of the second sub-layer 120b. Together, the first and second p-doped regions 114a, 114b and the second sub-layer 120b form part of the p-type MOSFET.

The second lateral side is arranged opposite to the first lateral side. Hence, it is implied that the first n-doped S/D regions 112a, 112b are arranged opposite to the first p-doped S/D regions 114a, 114b.

The S/D regions 112a, 112b, 114a, 114b may be formed by a method as known per the art. The formation of the S/D regions 112a, 112b, 114a, 114b may comprise the step of a metal contact deposition. In other words, the S/D regions 112a, 112b, 114a, 114b may comprise a metal suitable for being a contact for a S/D region.

The second sub-layer 120b may comprise Si₁₋ₓGeₓ. In this context, x may be equal to or less than 1. For instance, x may be 1; 0.9; 0.8; 0.7; 0.6; 0.5; 0.4; 0.3; 0.2; or 0.1. The first sub-layer 120a may comprise Si.

The first and second sub-layers 120a, 120b may be subject to strain. For instance, the first sub-layer 120a may be tensilely strained. The second sub-layer 120b may be compressively strained.

A conduction band edge of the first sub-layer 120a has an energy below a conduction band edge of the second sub-layer 120b. Further, a valence band edge of the first sub-layer 120a has an energy below a valence band edge of the second sub-layer 120b. It is implied that the first channel layer 120 may be formed of a heterostructure. In other words, the first sub-layer 120a may be formed of a material being different from that of the second sub-layer 120b. The material of the sub-layers 120a, 120b may be chosen to reduce leakage current, and to optimize either electron or hole conduction.

The term "band offset" herein refers to the relative alignment of the energy bands at a semiconductor heterojunction. Accordingly, the energy difference between the conduction band edge of the first sub-layer 120a and the conduction band edge of the second sub-layer 120b may be expressed as a band offset. An energy difference, i.e. the band offset, between the conduction band edge of the second sub-layer 120b and the conduction band edge of the first sub-layer 120a may be greater than 100 meV. Similarly, an energy difference between the valence band edge of the second sub-layer 120b and the valence band edge of the first sub-layer 120a may be greater than 100 meV. As discussed above, these configurations may reduce the leakage current during forward biasing of the CMOS device 100. Further, an energy difference between the conduction band edge of the first sub-layer 120a and the valence band edge of the second sub-layer 120b may be equal to or greater than 400 meV. This configuration may further reduce the leakage current. The above configurations may be achieved by the first sub-layer 120a being formed of e.g. Si. The second sub-layer may simultaneously be formed of Ge. Alternatively, the second sub-layer could be formed of e.g. Si_{0.5}Ge_{0.5} or Si_{0.75}Ge_{0.25}. Also, the merit of the first and second sub-layers 120a, 120b being formed as nanosheets may provide the above band offsets although other geometries are conceivable.

Still with reference to Fig. 1a, a plane of the first channel layer 120 is arranged parallel to the substrate 102. The first and second n-doped S/D regions 112a, 112b abut a lateral side surface of the first sub-layer 120a. As noted above, the first channel layer 120 need not be in abutment with the underlying substrate 102. To this end, it is conceivable that the first and second n-doped S/D regions 112a, 112b may further abut a bottom surface of the first sub-layer 120a. Similarly, the first and second p-doped S/D regions 114a, 114b abut a lateral side surface of the second sub-layer 120b. It is also conceivable that the first and second p-doped S/D regions 114a, 114b may further abut a top surface of the second sub-layer 120b.

Contrary to what is indicated in Fig. 1a, it is conceivable that the first and second sub-layers 120a, 120b need not overlap completely. For instance, the second sub-layer 120b may e.g. be further extended in the y-direction or the x-direction, such that the second sub-layer 120b protrudes beyond the first sub-layer 120a in said respective direction. By way of another example, the second sub-layer 120b may be protracted inwardly from the perimeter of the first sub-layer 120a. Hence, it is implied that the first and second sub-layers 120a, 120b may partially overlap. It is appreciated that the sub-layers 120a, 120b may be dimensioned in a variety of ways such that they are partially overlapping. To that end, it is conceivable that the first and second n-doped S/D regions 112a, 112b may, simultaneously, abut a top surface of the first sub-layer 120a; a bottom surface of the first sub-layer 120a; and a lateral side surface of the first sub-layer 120a. Similarly, the first and second p-doped S/D regions 114a, 114b may, simultaneously, abut a top surface of the second sub-layer 120b; a bottom surface of the second sub-layer 120b; and a lateral side surface of the second sub-layer 120b.

It should be noted that other sequential arrangements of any of the layers/elements of the CMOS device 100 is conceivable. For instance, while the first sub-layer 120a is depicted as being a bottom layer with respect to the substrate 102, it is contemplated that the second sub-layer 120b may be the bottom layer, and the first sub-layer 120a may be the top layer.

Still with reference to Fig. 1a, a second channel layer 122 is arranged above the first channel layer 120. The second channel layer 122 comprises a first sub-layer 122a and a second sub-layer 122b. There is arranged a gap between the first channel 120 and the second channel 122. In that gap there may be arranged an intermediate layer. Such an intermediate layer may be e.g. a part of a wrap-around-gate structure, or a dielectric layer. Whenever there is a reference to the second channel layer 122, the above discussions about the first channel layer 120 and its sub-layers 120a, 120b concerning band-alignment, geometry, dimensions, material, arrangement etc, are equally applicable to the second channel layer 122 and its sub-layers 122a, 122b, unless otherwise stated.

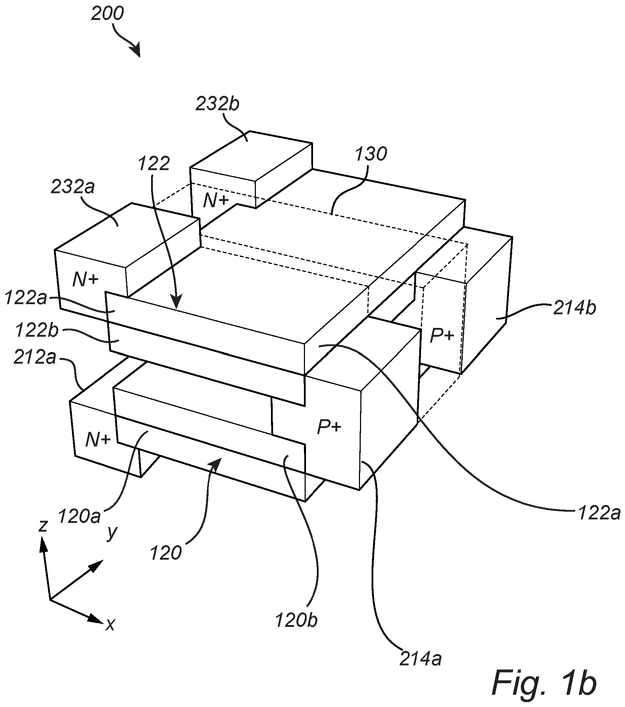

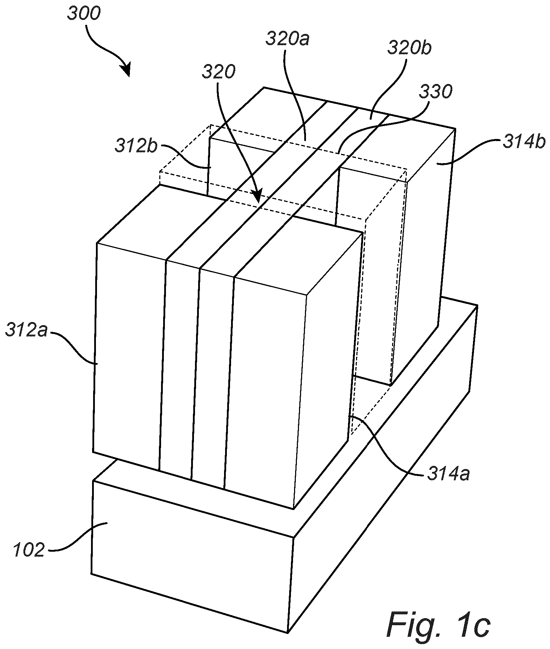

In the following, the arrangements of the sub-layers, relative to each other, of the first channel layer 120 and the second channel layer 122 will now be further discussed. The second sub-layer 120b of the first channel layer 120 is arranged above the first sub-layer 120a of the first channel layer 120. Further, the second sub-layer 122b of the second channel 122 is arranged below the first sub-layer 122a of the second channel 122 layer. As illustrated in Fig. 1 a, it is implied that the second sub-layer 120b of the first channel layer 120 directly faces the second sub-layer 122b of the second channel 122. As noted above, other sequential arrangements of any of the layers/elements of the CMOS device 100 is conceivable. As such, it is contemplated that the first sub-layer 120a of the first channel layer 120 may be arranged above the second sub-layer 120b of the first channel layer 120. Accordingly, the first sub-layer 122a of the second channel 122 may be arranged below the second sub-layer 122b of the second channel 122 layer. It is implied that the first sub-layer 120a of the first channel layer 120 may, in this case, directly face the first sub-layer 122a of the second channel 122.

A gate structure 130 abuts the second channel 122, and more specifically both of the first and second sub-layers 122a, 122b. More specifically, the gate structure 130 may abut a top major surface, and lateral sides of the first sub-layer 122a. Likewise, the gate structure 130 may abut a bottom major surface, and lateral sides of the second sub-layer 122b. The gate structure 130 may also abut the first channel 120, and more specifically the first and second sub-layers 120a, 120b. For instance, the gate structure 130 may abut a top major surface, and lateral sides of the second sub-layer 120b. Likewise, the gate structure 130 may abut a bottom major surface, and lateral sides of the first sub-layer 120a. It is conceivable that the gate structure 130 forms a wrap-around-gate (i.e. GAA). This GAA may surround the first and second channel layers 120, 122. In other words, the gate structure 130 may abut a bottom surface, a top surface, and a lateral surface of each of the first and second channel layers 120, 122. Hence, the gate structure 130 may control both of the first and second channel layers 120, 122. It is further implied that the gate structure 130 may extend between the first and second channel layers 120, 122.

The CMOS device 100 further comprises first and second n-doped S/D regions 132a, 132b associated with the second channel 122. Thus, the first and second n-doped S/D regions 132a, 132b may form part of another n-type MOSFET. The CMOS device 100 further comprises first and second p-doped S/D regions 134a, 134b associated with the second channel 122. Thus, the first and second p-doped S/D regions 134a, 134b may form part of another p-type MOSFET. Whenever there is a reference to the first and second n-doped S/D regions 132a, 132b / first and second p-doped S/D regions 134a, 134b, the above discussions about the first and second n-doped S/D regions 112a, 112b / first and second p-doped S/D regions 114a, 114b concerning geometry, dimensions, material, arrangement etc., are equally applicable to the first and second n-doped S/D regions 132a, 132b / first and second p-doped S/D regions 134a, 134b, unless otherwise stated.

Along a bottom-up direction, the layers/elements of the CMOS device 100 may thus be arranged in the following order: substrate 102; first sub-layer 120a and first and second n-doped source/drain regions 112a, 112b; second sub-layer 120b and first and second p-doped source/drain regions 114a, 114b; second sub-layer 122b and first and second p-doped source/drain regions 134a, 134b; first sub-layer 122a and first and second n-doped source/drain regions 132a, 132b.

However, as noted above, other sequential arrangements of any of the layers/elements of the CMOS device 100 is conceivable. For instance, along a bottom-up direction, the layers/elements of the CMOS device 100 may alternatively be arranged in the following order: substrate 102; second sub-layer 120b and first and second p-doped source/drain regions 114a, 114b; first sub-layer 120a and first and second n-doped source/drain regions 112a, 112b; first sub-layer 122a and first and second n-doped source/drain regions 132a, 132b; second sub-layer 122b and first and second p-doped source/drain regions 134a, 134b.

Referring now to Fig. 1b, a second CMOS device 200 is illustrated, for illustrative purposes the substrate is not shown. The CMOS device 200 is similar to the first CMOS device 100 as illustrated in Fig. 1a. Therefore, for sake of brevity, a detailed discussion about the CMOS device 200 has been omitted. Unless otherwise stated, whenever there is a reference to any layer/element, the above discussions about corresponding layer/element in the first CMOS device 100 concerning geometry, dimensions, material, arrangement etc., are equally applicable to the layer/element in the second CMOS device 200. In any case, a main difference between the second CMOS device 200 and the first CMOS device 100 is the presence of first and second p-doped S/D regions 214a, 214b associated with both the first channel layer 120 and the second channel layer 122. Hence, a single unit of a respective first and second p-doped S/D region 214a, 214b abuts and is associated with both the first and second channel layers 120, 122. In contrast, the first CMOS device 100 comprises separate first and second p-doped S/D regions 114a, 114b associated with the first channel layer 120, and separate first and second p-doped S/D regions 134a, 134b associated with the second channel 122. The first and second p-doped S/D regions 214a, 214b extend between the first and second channel layers 120, 122. The first and second p-doped S/D regions 214a, 214b abut the second sub-layers 120b, 122b of the first and second channel layers 120, 122.

Another main difference between the second CMOS device 200 and the first CMOS device 100, is that first and second n-doped S/D regions 212a, 212b (associated with the first channel layer 120) further abut a bottom surface of the first channel layer 120 (i.e. abut the bottom of the first sub-layer 120a). Similarly, first and second n-doped S/D regions 232a, 232b (associated with the second channel layer 122) abut a top surface of the second channel layer 122 (i.e. abut the top of the first sub-layer 122a). Again, the sequential arrangement of the layers/elements may vary (e.g. the first sub-layers 120a, 122a may directly face each other). Hence, it is conceivable that the first and second n-doped S/D regions 212a, 212b may alternatively form a single unit and further abut the first sub-layers 120a, 122a of the first and second channel layers 120, 122 simultaneously. In that case, there would be provided separate p-doped S/D regions associated with the first channel layer 120, and separate p-doped S/D regions associated with the second channel layer 122.

Referring now to Fig. 1c, a third CMOS device 300 is illustrated. The third CMOS device 300 comprises the substrate 102, a first channel layer 320 comprising first and second sub-layers 320a, 320b. The third CMOS device 300 further comprises first and second n-doped S/D regions 312a, 312b associated with the first sub-layer 320a (i.e. these form part of a n-type MOSFET). The third CMOS device 300 further comprises first and second p-doped S/D regions 314a, 314b associated with the second sub-layer 320b (i.e. these form part of a p-type MOSFET). A main difference between the third CMOS device 300 and the first and second CMOS devices 100, 200 is that a (main) plane of the first channel layer 320 is arranged perpendicular to the substrate 102. Hence, the first channel layer 320 and its sub-layers 320a, 320b may be formed as fins, instead of e.g. nanosheets, that have a major protrusion in the z-direction. The first and second n-doped S/D regions 312a, 312b are arranged at a first lateral side of the channel layer 320 (i.e. abut a lateral side of the first sub-layer 320a). The first and second p-doped S/D regions 314a, 314b are arranged at a second lateral side of the channel layer 320 (i.e. abut a lateral side of the first sub-layer 320b). The first lateral side is arranged opposite to the second lateral side.

A gate structure 330 may, as illustrated straddle the channel layer 320. The illustrated gate structure 330 abut the first and second sub-layers 320a, 320b of the first channel layer 320. The first channel layer 320 may be arranged above the substrate 102 such that there is a gate portion therebetween. As an alternative to a straddling gate structure, the gate structure 330 may be formed as a GAA that extends between the substrate 102 and the first channel layer 320.

It is appreciated that the above discussions concerning e.g. formation methods and material choices of the substrate, the S/D regions, and the channel layers are equally applicable to the corresponding layers/elements of the CMOS device 300.

Irrespective of the first, second, and third CMOS device 100, 200, 300, the first and second sub-layers of the first channel layer may be arranged within a distance of 1-10 nm (e.g. 1, 2, 3, 4, 5, 6, 7, 8, 9, or 10 nm). This is equally applicable to any second channel layers. In other words, the first and second sub-layers of the second channel layer may be arranged within a distance of 1-10 nm (e.g. 1, 2, 3, 4, 5, 6, 7, 8, 9, or 10 nm).

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A complementary metal-oxide-semiconductor (CMOS) field effect device (100; 200; 300) comprising:
a substrate (102);
a first n-doped source/drain region, S/D region, (112a; 212a; 312a) and a second n-doped S/D region (112b; 212b; 312b), arranged above the substrate (102);
a first p-doped S/D region (114a; 214a; 314a) and a second p-doped S/D region (114b; 214b; 314b), arranged above the substrate (102);
a first channel layer (120, 320) arranged above the substrate (102), the first channel layer (120; 320) comprising:
a first sub-layer (120a; 320a) and a second sub-layer (120b; 320b);
wherein the first and second n-doped S/D regions (112a; 212a; 312a, 112b; 212b; 312b) are arranged at a first lateral side of the first channel layer (120; 320), and the first and second p-doped S/D regions (114a; 214a; 314a, 114b; 214b; 314b) are arranged at a second lateral side of the first channel layer (120; 320), the second lateral side being opposite to the first lateral side;
wherein the first and second n-doped S/D regions (112a; 212a; 312a, 112b; 212b; 312b) abut the first sub-layer (120a; 320a) but not the second sub-layer (120b; 320b);
wherein the first and second p-doped S/D regions (114a; 214a; 314a, 114b; 214b; 314b) abut the second sub-layer (120b; 320b) but not the first sub-layer (120a; 320a);
wherein a conduction band edge of the first sub-layer (120a; 320a) has an energy below a conduction band edge of the second sub-layer (120b; 320b); and
wherein a valence band edge of the first sub-layer (120a; 320a) has an energy below a valence band edge of the second sub-layer (120b; 320b); and
a gate structure (130; 330) abutting the first and second sub-layers (120a; 320a, 120b; 320b) of the first channel layer (120; 320).

2. The CMOS device (100; 200; 300) according to claim 1, wherein the second sub-layer (120b; 320b) comprises Si₁₋ₓGeₓ, wherein x is equal to or less than 1.

3. The CMOS device (100; 200; 300) according to any one of the preceding claims, wherein the first sub-layer (120a; 320a) comprises Si.

4. The CMOS device (100; 200; 300) according to any one of the preceding claims, wherein the first sub-layer (120a; 320a) is tensile strained, and wherein the second sub-layer (120b; 320b) is compressive strained.

5. The CMOS device (100; 200; 300) according to any one of the preceding claims, wherein an energy difference between the conduction band edge of the first sub-layer (120a; 320a) and the valence band edge of the second sub-layer (120b; 320b) is equal to or greater than 400 meV.

6. The CMOS device (100; 200; 300) according to any one of the preceding claims, wherein an energy difference between the conduction band edge of the second sub-layer (120b; 320b) and the conduction band edge of the first sub-layer (120a; 320a) is greater than 100 meV; and
wherein an energy difference between the valence band edge of the second sub-layer (120b; 320b) and the valence band edge of the first sub-layer (120a; 320a) is greater than 100 meV.

7. The CMOS device (100; 200) according to any one of the preceding claims,
wherein a plane of the first channel layer (120) is arranged parallel to the substrate (102);
wherein the first and second n-doped S/D regions (112a; 212a, 112b; 212b) abut at least one of: a top surface of the first sub-layer (120a); a bottom surface of the first sub-layer (120a); a lateral side surface of the first sub-layer (120a), and
wherein the first and second p-doped S/D regions (114a; 214a, 114b; 214b) abut at least one of: a top surface of the second sub-layer (120b); a bottom surface of the second sub-layer (120b); a lateral side surface of the second sub-layer (120b);

8. The CMOS device (200) according to claim 7, further comprising:
a second channel layer (122) arranged above the first channel layer (120) comprising:
a first sub-layer (122a) and a second sub-layer (122b);
wherein the second sub-layer (120b) of the first channel layer (120) is arranged above the first sub-layer (120a) of the first channel layer (120), and the second sub-layer (122b) of the second channel (122) is arranged below the first sub-layer (122a) of the second channel (122) layer, and wherein the first and second p-doped S/D regions (214a, 214b) abut the second sub-layers (120b, 122b) of the first and second channel layers (120, 122), or
wherein the first sub-layer (120a) of the first channel layer (120) is arranged above the second sub-layer (120b) of the first channel layer (120), and the first sub-layer (122a) of the second channel (122) is arranged below the second sub-layer (122b) of the second channel layer (122), and wherein the first and second n-doped S/D regions (112a, 112b) abut the first sub-layers (120a, 122a) of the first and second channel layers (120, 122).

9. The CMOS device (200) according to claim 8, wherein the gate structure (130) is further abutting the first and second sub-layers (122a, 122b) of the second channel layer (122).

10. The CMOS device (200) according to claim 8 or 9, further comprising first and second n-doped S/D regions (232a, 232b) associated with the second channel (122), and first and second p-doped S/D regions (214a, 214b) associated with the second channel (122).

11. The CMOS device (300) according to any one of claims 1-6, wherein a plane of the first channel layer (320) is arranged perpendicular to the substrate (102).
